# EUROPEAN PATENT APPLICATION

(11) **EP 3 069 953 A1**
(43) Date of publication of application: **21.09.2016**
(21) Application number: 16160783.3
(22) Date of filing: 16.03.2016
(51) Int. Cl.: B61L 1/20, H01H 47/00

(54) **RELAY STATE MONITORING OF RAILWAY SAFETY RELAYS**

(30) Priority: 17.03.2015 NL 2014468; 15.03.2016 NL 2016440
(71) Applicant: VolkerRail Nederland BV, 4131 NJ Vianen (NL)
(72) Inventor: Steentjes, Noël, 4131 NJ Vianen (NL)
(74) Representative: Assendelft, Jacobus H.W.

(57) **Abstract**

The invention relates to measuring, with a measuring device with a detector, a radiation, such as magnetism or light, which originates from the interior space of the housing of a B-relay. This radiation leaves this internal space and comes in the immediate vicinity of the housing of the B-relay, in which immediate vicinity the measuring device measures this radiation with the detector. A relay box contains a large number of relays. These relays are in an own relay housing which is provided with a for a radiation coming from the housing sensitive external, individual detector. This relay box is associated with a railroad and applied to security level in the management and control of switches or railway crossings, or used for track occupancy detection, such as a so-called repeat relay.

## Description

This invention relates to monitoring of the relay position of a safety relay (so-called. B1 relay) in a railway application, in particular relays that are applied to security level in the control and monitoring of switches or railway crossings or be used for track occupancy detection, such as a so-called repeat track relay (TPR relay).

A B-Relay is a relay with a security function in a railway security system (including NX safety). B relays have a very high degree of reliability, and operate for decades, provided they are regularly revised. Important features of B relays are that they for sure loose contact when the coil is not energized, and the normally closed break contacts ("back contact") open before make contacts ("front contact") are closed. There exist several types of B-relay, with specific properties. The most common type is the 56001-783Gr1. This relay has two coils that operate on 12V DC, four switch contacts ("full contacts"), two make contacts and one break contact. Furthermore, there are B-relays which engage with a delay, disengage with a delay, are suitable for large currents etc. Another type of B-relay is the track relay (TR). This relay is a part of a track circuit, and is "on" when a track section is unoccupied, and falls off as the track section is occupied by a train.

A safety relay is supplied by the manufacturer in a sealed container. The rear wall of the casing is equipped with contact ports that correspond to contact plugs (so-called terminals) which project from a contact block in the relay box. A B relay is mounted by pressing his back against the contact block so that the terminals are inserted into the contact ports so the B relay, via to the terminals connected wires, is electrically connected to the relevant circuit in which the B relay must be included. If the housing after delivery by the factory is modified or damaged or the seal becomes broken, the product is rejected. Up to now, therefore, only the power wires connected to the terminals were used for the relay state monitoring.

FR A 2731974 discloses the placing of a sensor working with Hall effect around a lead wire connected to a safety relay. The sensor reacts to the magnetic field generated by current flowing through the conductor. From practice it is known to put a separate, so-called current clamp on a wire which is connected to a B1 relay. This clamp is also working with Hall effect and constitutes a with FR 2731974 A functionally corresponding sensor. Both types of sensors form a magnetic field sensitive closed ring of weak iron around the conductor.

The object of the invention is an improved relay position monitoring, where the improvement is one or more of: fast and reliable installation of the monitoring; reliability of the monitoring; independence of the way in which the monitoring relay is installed; another advantage.

To achieve the object of the invention, it is proposed with a measuring apparatus with a detector to measure a radiation coming from the interior space of the housing of the B-relay and by passing a bounding wall of the housing of the B-relay leaving this inner space and coming in the immediate vicinity of the housing of the B-relay, in which immediate vicinity the measuring device measures this radiation with the detector. In addition, the detector is via a wired or wireless (e.g. RF) link connected to an input of a computer of a relay position monitoring system, so that the measurement signal of the detector can be fed to the computer for processing.

The radiation which is measured is, for example, light or a magnetic field, for which radiation the detector is sensitive. This radiation originates from inside the housing of the B-relay and is preferably generated inside this housing, for example, when the radiation is a by a galvanic coil contained in the internal space induced magnetic field. Alternatively, the radiation is generated outside the housing, enters through a boundary wall the inner space and then leaves the interior space through a boundary wall, for example, when the radiation is ambient light.

For the interior space of the housing of the B-relay preferably one or more of the following applies: is single; contains one or more of a single or double galvanic magnet coil, preferably with soft-iron core, an armature, a return spring of the armature, a change-over contact, a normally open contact, a normally closed contact; contains all the components of the B-relay; is hermetically sealed with respect to its surroundings; is sealed against unauthorized access; has a boundary wall which is transparent to the radiation to which the measuring device is sensitive; at least one or two, preferably mutually parallel and / or straight, mounting sleeves extend through it out, with respect to its sealed, and by the two opposite end boundary walls around culminating in the environment, so that a protruding on either side mounting pin in a mounting sleeve can be inserted (in a relay box is for each B relay a pair of mutually parallel, fixed mounting pins available in which a B-relay housing is simply raised so that its rear wall is placed against the contact block, and then nuts are threaded onto the from the front wall of the B relay housing protruding threaded ends of the mounting pins so that the B-relay housing unslidable remains on the mounting pins); from this space one or more galvanic conductors project sealingly through a boundary wall into the environment; only one or more galvanic conductors extend from the space in the vicinity; the galvanic conductors are electrically connected to one or more components in this space, such as a magnet coil or a switching contact.

For the detector preferably one or more of the following applies: is a Hall sensor, preferably of the bipolar type; is placed outside the relay housing, is preferably at a distance of less than 5 or 10 mm below the relay housing placed; is, seen in top view, placed at a distance between the front and rear wall, preferably at a distance of more than 10 or 30 mm from the front and / or rear wall of the relay housing, more preferably about halfway down the length of the relay housing; is, seen in top view, placed at a distance between the two opposite side walls of the relay housing, preferably at a distance of more than 10 or 20 mm from the one and / or other side wall, more preferably about midway between them; is located right under the relay magnetic coil; is located in the vicinity of a concentrate body that concentrates the by the detector detected radiation, such as magnetic field, on the detector, for example, which concentrate body is made of metal, e.g., aluminum, soft iron or ferrite material, preferably wherein the concentrate body is located at a maximum of 5 or 10 mm from a different horizontal level with the detector, more preferably the concentrate body has a space or gap in which the detector is being incorporated, preferably exactly suitable, preferably wherein the concentrate body is elongated and extending in longitudinal direction of the relay housing and / or horizontal and / or parallel to the relay coil and / or straight extending below the relay coil; concentrate body is outside the relay housing; is, preferably as a unit with the concentrate body, adjustable, preferably stepfree, mounted to an immobile chassis mounted to the relay housing, preferably adjustable in the longitudinal direction of the relay housing, for example, via a slotted hole in the chassis.

The measuring device is preferably equipped with a microcontroller or similar computing device, provided with a memory in which a stored reference value with which the signal coming from the detector is compared in order to determine, on the basis thereof, the relay position.

It is preferred to apply a bipolar detector, such as a bipolar Hall sensor. This is based on the knowledge developed by the inventor that a relay during switching generates a momentary magnet peak causing a measurement interference in a unipolar Hall sensor. This not from the state of the art known phenomenon, was established by the inventor experimentally by chance from a field test with B relay of different, in the Netherlands typical, type according to a representative test carried out with a detector of unipolar type. With 75% of the tested B relay the result turned out to not match with the predictions based on research on laboratory scale. Initially this was a disappointing result which caused to stop the development of this measuring device. In a subsequent test the offending phenomenon was disappeared inexplicably. Further investigation showed that in the later test by mistake a bipolar Hall sensor was used. Next, by meticulous research in the laboratory, arose the knowledge why a unipolar indeed and a bipolar Hall sensor does not cause interference. Tolerances of the level of the supply voltage, galvanic property of components (such as the magnetic coil) of the relay and of the measuring device (such as the Hall sensor) appear to lead to unstable result of the detection at a unipolar Hall sensor. The fault, which could be called "contra pulse in the magnetic field", is incorrectly interpreted by the microcontroller as the relay switches.

Preferably, the bipolar detector is applied to a direction sensitive relay. It is determined that a direction sensitive relay, in particular, shows the magnet peak during switching.

The measuring device preferably includes an electronic filter which is connected to the detector so that the signal coming from the detector is first filtered prior to being fed into the microcontroller. This filter is preferably one or more of a high-pass, low-pass or band-pass filter.

For the chassis, preferably one or more of the following applies: is preferably made of sheet material, for example metal; is substantially U-shaped in cross-section; takes the relay housing between the legs of the U; extends substantially over the entire length and / or height of the relay housing; covers substantially the entire bottom and / or side walls of the relay housing; forms an open-topped, preferably parallelepipedic container of which preferably one or more of the top wall, front and rear walls are missing; possesses a with the front wall of the relay housing blocking cooperating stop in order to prevent movement of the chassis in the one longitudinal direction of the relay housing; the detector is located at a distance between the bottom wall of the chassis and the bottom wall of the relay housing; is equipped with galvanic isolators in the mounting area with the relay housing in order to isolate the chassis galvanically completely from the relay housing and from the fastening means, for example a galvanically insulating U-shaped bracket; provides the detector a Faraday cage, or the like shielding against a magnetic field from the environment; has a size and shape so that in addition to the two mounting pins, an air gap is present everywhere, respectively, lack a touch pad, with the relay housing and, possibly, the frame belonging to the relay box, in which the relay housing is mounted; is wider than the relay housing; ends with his back forward from the back side of the relay housing.

To the U-shaped bracket preferably one or more of the following applies: is of sheet material; the two legs connect to the side walls of the chassis, preferably about halfway down the height of the side walls; the legs are integral with the side walls; the legs are covered with electrical insulating material preferably over substantially the full length, for example, coated with an insulating sleeve; the web between the legs is completely of insulating material; the web contains two holes for plugging onto the threaded ends of the two mounting pins on which the B-relay housing is placed; the legs have an at approximately right angles bent end that overlaps with the web and with which the legs are fixed to the web; the web has an at least 10% greater height than a leg; the height of a leg is less than 30% or 50% of the height of the chassis; the length of a leg is at least 15 or 20 mm; the legs run substantially parallel to the mounting pins and / or at a level at a distance below the mounting pins; relative to the longitudinal direction of the mounting pins is the web of the U spaced forwardly of the chassis.

In a preferred embodiment, the detector is sensitive to the magnetic field generated by the galvanic magnetic coil of the relay-B and to this end has been placed outside the relay housing at the shortest possible distance from the galvanic coil. Thus, direct measurement is applied to the component of the relay which initiates switching from the one to the other condition of the relay.

In an alternative, the detector is a reed switch or other magnetic switch, for example a semiconductor component. In the measuring device, a RFID chip can be used to work together with the detector, or to provide it. The detector may be sensitive to (visible or IR) light, for example form part of a light barrier. For example, the detector is arranged within the measuring device so that it may or may not catch a to the light barrier belonging light beam, which beam is indeed or not hampered by a movable component contained in the relay housing that moves by switching of the relay between two positions corresponding with the two switching positions of the relay, in one of which two positions the component indeed and in the other position does not obstruct or block the light beam.

The invention will be further described on the basis of the drawing. In these drawings:
Fig. 1 is a perspective view of the relay housing;
Fig. 2 is a photograph of a B-relay;
Fig. 3 shows an example of a chassis, in perspective;
Fig. 4 is a photo of a detail of a within the relay box mounted B-relay with chassis.

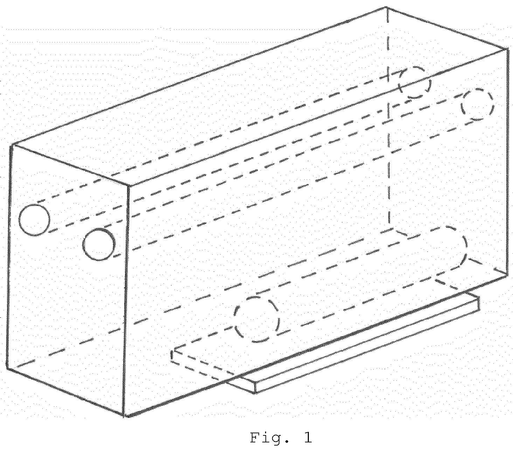

Fig. 1 shows the block-shaped relay housing which seals a single internal space hermetically from the environment. At a high level run two parallel, straight mounting sleeves through the interior space and project through both end walls. These mounting sleeves are sealed relative to the interior space. A mounting pin longer than the sleeve can project out of the tube at both tube ends.

The inner space contains all the components of the B-relay, of which only the solenoid is shown. This is at low level. This solenoid switches the relay.

Outside the housing, at a short distance directly below the magnet coil is part of the detector which is illustrated as a plate. The detector comprises in this embodiment a bipolar Hall sensor with which the magnetic field of the magnetic coil is registered.

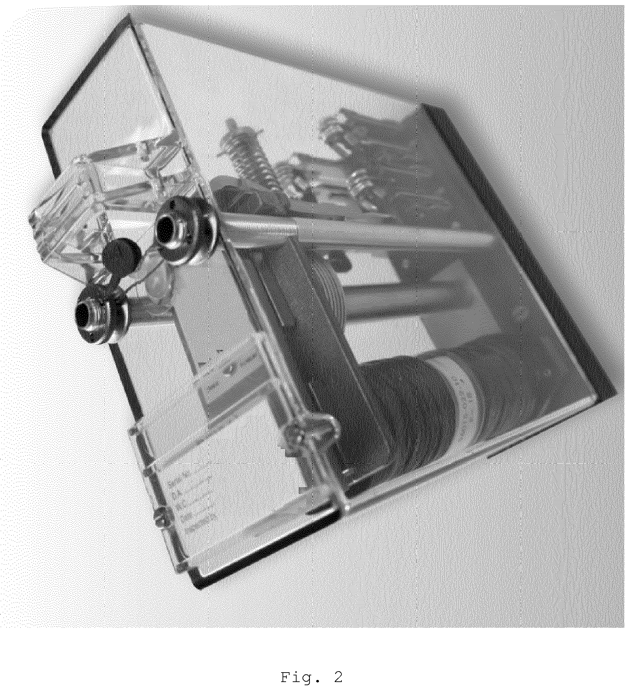

Fig. 2 again shows the block-shaped, hermetically sealed relay housing and now all components of the B-relay inside the relay housing, including: galvanic magnetic coil with soft iron core, an anchor, a reset spring of the anchor, a switch contact, a make contact, a break contact. The mounting sleeves are also visible. The plate-shaped detector is not visible in fig. 2.

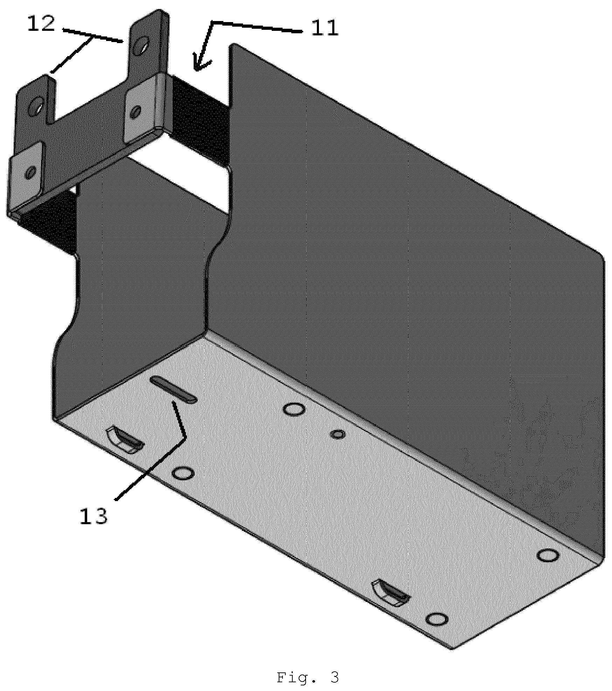

Fig. 3 shows the sheet metal chassis, with integral U-shaped bracket with legs 11 and onto the mounting pins to be located holes 12 in the web. The legs 11 have angled tabs that hold the separate web. The legs 11 are coated with insulating sleeves and the web is located forwardly of the chassis. The slotted hole 13 in the bottom of the chassis provides the detector in the longitudinal direction infinitely adjustability with respect to the relay housing.

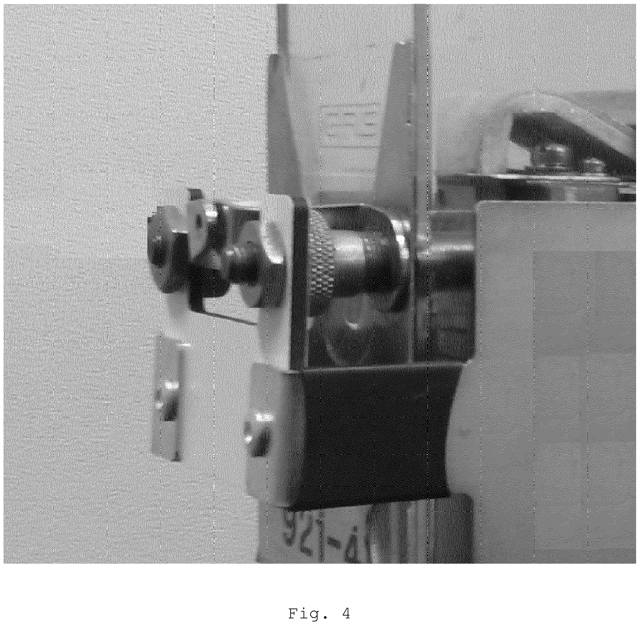

Fig. 4 shows the thread ends of the two mounting pins which project forward out of the relay housing and on which nuts are screwed with round knurling are screwed in order to hold the relay housing. Onto the beyond these nuts forwardly projecting portion of the thread ends is put the web of the U-bracket of the chassis and is retained by hexagonal nuts screwed on the threaded ends. Apart from the mounting pegs the chassis has an air gap everywhere, so no contact with the relay housing or frame in which the relay housing is mounted.

## Claims

1. Measuring, with a measuring device with a detector, a radiation, such as magnetism or light, which originates from the interior space of the housing of the B-relay and by passing a bounding wall of the housing of the B-relay leaves this internal space and comes in the immediate vicinity of the housing of the B-relay, in which immediate vicinity the measuring device measures this radiation with the detector.

2. Relay box which contains a large number of relays of which at least one, or all, relays are in an own relay housing which is provided with a for a radiation coming from the housing sensitive external, individual detector, said relay box is associated with a railroad, in particular contains relays in its own relay housing, applied to security level in the management and control of switches or railway crossings, or used for track occupancy detection, such as a so-called repeat relay.

3. Relay, for example for the relay box according to claim 2 or the method of claim 1, in a separate relay housing provided with an external, individual detector which is sensitive to a radiation coming from the relay housing.

4. Relay according to claim 3, wherein the detector is located at a distance of less than 10 mm below and, seen in top view, at a distance of more than 10 mm between the front and rear walls and at a distance of more than 10 mm between the two opposite side walls of the relay housing directly below the relay magnet coil.

5. Relay according to claim 3 or 4, wherein the detector is adjustably mounted to an immobile on the relay housing mounted chassis.

6. Relay according to any one of claims 3-5, wherein the detector is mounted on a chassis, which chassis is mounted to the relay housing by plugging onto the threaded ends of the two mounting pins onto which the B-relay housing is plugged and the chassis is equipped with galvanic insulators in the mounting area with the relay housing.

7. Relay according to any one of claims 3-6, the detector is located at a distance between the bottom wall of the chassis and the bottom wall of the relay housing.

8. Relay according to any one of claims 3-7, wherein the detector is a bipolar detector, such as a bipolar Hall sensor.

9. Relay according to any one of claims 3-8, which is a direction sensitive relay.

10. Relay according to any one of claims 3-9, which is a safety relay is in a railway application, in particular a relay which is applied at security level in the control and monitoring of switches or railway crossings or used for track occupancy detection, such as a so-called track repeat relay.
